# EUROPÄISCHE PATENTSCHRIFT

(11) **EP 0 772 124 B1**
(45) Veröffentlichungstag und Bekanntmachung des Hinweises auf die Patenterteilung: **12.12.2001**
(21) Anmeldenummer: 96115254.3
(22) Anmeldetag: 24.09.1996
(51) Int. Cl.: G06F 11/00

(54) **Speicherablaufsteuerung eines Rechners für den Leitstand einer Druckmaschine**
Memory flow control for a computer controlling a printing machine
Commande à séquences des mémoires dans un ordinateur pour le contrôle d'une machine d'impression

(30) Priorität: 26.10.1995 DE 19539794
(43) Veröffentlichungstag der Anmeldung: 07.05.1997
(73) Patentinhaber: MAN Roland Druckmaschinen AG, 63075 Offenbach (DE)
(72) Erfinder: Duschl, Dieter, Dr., 63071 Offenbach (DE); Schlitz, Thomas, 63165 Mühlheim (DE)
(74) Vertreter: Stahl, Dietmar

(56) Entgegenhaltungen:
- US-A- 5 155 827
- COMPUTERS & SECURITY, Bd. 11, Nr. 6, Oktober 1992, OXFORD GB, Seiten 563-579, XP000332272 COHEN F B: "DEFENSE-IN-DEPTH AGAINST COMPUTER VIRUSES"
- IBM TECHNICAL DISCLOSURE BULLETIN, Bd. 37, Nr. 7, 1.Juli 1994, Seite 5/6 XP000455419 "AUTOMATIC IPL DRIVE SWITCH"
- COMPUTERS & SECURITY, Bd. 9, Nr. 5, August 1990, OXFORD GB, Seiten 431-446, XP000147838 MCKOSKY R A ET AL: "A FILE INTEGRITY CHECKING SYSTEM TO DETECT AND RECOVER FROM PROGRAM MODIFICATION ATTACKS IN MULTI-USER COMPUTER SYSTEMS"

## Beschreibung

Die Erfindung betrifft einen Rechner für den Leitstand einer Druckmaschine gemäß dem Oberbegriff von Anspruch 1.

Der Druckprozeß wird heute zunehmend von einem Leitstand aus gesteuert und überwacht. Von einem Leitstand aus können die verschiedensten Komponenten sowie Stellglieder in ihrem Ist-Zustand überwacht und entsprechend den Prozeßbedürfnissen verstellt werden. Über einen Druckmaschinen-Leitstand erfolgt auch die Erfassung, Verwaltung sowie Bearbeitung von Daten der Druckaufträge. Als Daten sind beispielsweise Auftragsnummer, Kundenname, Auflagenzahl, Termine, Qualitätsdaten usw. zu nennen.

Aus der DE 4 123 126 C1 ist dabei ein Rechner für den Leitstand einer Druckmaschine bekannt, welcher nach Art eines PC aufgebaut ist. Die Bedienung der Druckmaschine sowie die Auswahl von anzuzeigenden und zu verstellenden Größen erfolgt hierbei über eine menügeführte Benutzeroberfläche. Ferner ist als nicht flüchtiges, wieder beschreibbares Speichermedium eine Festplatte vorgesehen.

Bei Rechnern, welche mit nicht flüchtigen, wiederbeschreibbaren Speichermedien zusammenarbeiten, kann es - absichtlich oder unabsichtlich - zu Datenmanipulationen kommen. Insbesondere ausführbare Programme können derartig verändert werden, also daß eine ordnungsgemäße Funktion eines Rechners und somit auch eine Funktionssicherheit der Druckmaschine nicht mehr gewährleistet sind. Die bereits zitierte DE 4 123 126 C1 sieht demzufolge vor, Zugriffe auf Systemdaten des Rechners nur in Verbindung mit einer auf einer Diskette vorhandenen Code-Information, welches über das BIOS des Rechners gelesen wird, zuzulassen. Nicht zu vermeiden sind mit einem derartigen Rechnersystem jedoch Datenmanipulationen bzw. Zerstörungen von Daten, welche durch physikalische Einwirkungen auf das Speichermedium entstehen. Als Beispiel sei hier die Beschädigung der Festplatte durch den Schreib-Lesekopf in einem Sektor genannt. Eine weitere Form der Datenmanipulation liegt dabei in dem Einschleusen von sogenannten Computer-Viren oder wenn eine Datei mit der gleichen File-Bezeichnung einer noch nicht freigegebenen Programmversion anstelle des üblichen Files geschrieben wird. In diesen Fällen ist das Lesen der entsprechenden Datei wohl noch möglich, eine Ausführung dieser veränderten Dateien bedingt aber unter Umständen nicht vorhersehbare Funktionsabläufe bzw. Zustände des Rechnersystems. Das Einschleusen von Computer-Viren bzw. in sonstiger Weise veränderter Dateien kann dabei über Disketten, welche in das Laufwerk des Rechners eingelegt werden oder aber auch über Einrichtungen der Datenfernübertragung (Netzwerke) erfolgen.

Die DE 4 229 266 A1 schlägt zur Vermeidung von durch physikalischen Defekten verursachte Festplattenausfällen einen Rechner für den Leitstand einer Druckmaschine mit zwei Festplattenlaufwerken vor. Im Normalbetrieb arbeitet dieser Rechner mit einem Festplattenlaufwerk, wobei von Zeit zu Zeit bzw. programmgesteuert stets ein back-up von Daten auf das zweite Festplattenlaufwerk erfolgt. Wird beispielsweise während des Lesens einer Datei ein Defekt des Arbeits-Laufwerkes festgestellt, so erfolgt das Umsteuern auf das zweite Festplattenlaufwerk mittels einer speziellen Diskette. Das Feststellen eines physikalischen Defektes bzw. einer sonstwie hervorgerufenen Datenveränderung erfolgt somit erst beim Lesen der entsprechenden Datei. Das Rechnersystem ist somit erst nach dem Umsteuervorgang auf das zweite Festplattenlaufwerk wieder betreibbar.

Bekannt sind sogenannte Viren-Check-Programme (z.B. McAfee-Virenschutz), jedoch können diese Viren-Programme lediglich die zum Zeitpunkt ihrer Herstellung bekannten Viren aufspüren und somit entsprechende Fehlermeldungen zur Anzeige bringen. Dies hat seine Ursache darin, daß Viren-Programme die Festplatte nach bekannten Mustern (Strukturen) absuchen, was zu einem sehr zeitaufwendig ist, zum anderen das Entdecken noch unbekannter Viren mit völlig neuartiger Struktur unmöglich macht. Ferner ist es auch möglich, daß tatsächlich virenfreie Files als "verseucht" identifiziert werden, da diese zufällig eine auf einen Virus hinweisende Struktur aufweisen.

Aufgabe der vorliegenden Erfindung ist es daher, einen Rechner gemäß dem Oberbegriff von Anspruch 1 derartig weiterzubilden, so daß eine frühestmögliche Erkennung einer insbesondere durch physikalischen Defekt gestörten Datei bei weitestgehend übergangslosem Weiterbetreiben des Rechnersystems möglich ist.

Gelöst wird diese Aufgabe durch die kennzeichnenden Merkmale von Anspruch 1. Weiterbildungen der Erfindung ergeben sich aus den Unteransprüchen.

Nach der Erfindung ist der Rechner derartig ausgebildet, daß der wiederbeschreibbare, nicht flüchtige Speicher den Inhalt wenigstens einer Datei redundant in einer aufrufbaren und zur Ausführung bringbaren als auch in einer durch das Betriebssystem nicht aufrufbaren, nicht zur Ausführung bringbaren Form enthält, daß vor dem Übertragen des aufrufbaren und zur Ausführung bringbaren Inhaltes einer derartigen Datei von dem wiederbeschreibbaren, nicht flüchtigen Speicher in den wiederbeschreibbaren, flüchtigen Speicher (RAM) eine Überprüfung des Inhaltes der Datei gemäß vorgegebenen Kriterium durchführbar ist, und daß bei Nichterfüllen des Kriteriums die entsprechende Datei in einen nicht aufrufbaren Zustand sowie der zunächst nicht aufrufbare und zur Ausführung bringbare Inhalt der Datei in einen aufrufbaren und zur Ausführung bringbaren Zustand versetzbar und daraufhin der Inhalt in den wiederbeschreibbaren, flüchtigen Speicher (RAM) übertragbar ist.

Die Erfindung bietet den Vorteil, daß bei Feststellung eines physikalischen Defektes einer Datei, das Rechnersystem nahezu übergangslos und weitestgehend ohne Einschränkungen weiterbetreibbar ist. Es ergibt sich eine Erhöhung der Betriebssicherheit, Ausfallzeiten werden vermieden, da insbesondere bei einer Vielzahl von Störungen auf den Einsatz von Servicetechnikern verzichtet werden kann.

Wird während dem Zugriff auf eine Datei bzw. während des Bootens des Rechners in einer Datei bzw. einem Sektor einer Datei ein physikalischer Defekt festgestellt, so erfolgt das Umbenennen dieser lesbaren und zur Ausführung bringbaren Datei in eine vom Betriebssystem des Rechners nicht mehr aufrufbare Form. Durch dieses Umbenennen der Datei mit physikalischen Defekt in eine nicht zur Ausführung bringbare Datei verbleiben somit die Daten an ihrem physikalischen Ort, d.h. in den entsprechenden Sektoren der Festplatte. Da nach der Erfindung weiterhin vorgesehen ist, daß zumindest einige der zur Ausführung bringbaren Dateien, welche bspw. einen eingeschränkten Weiterbetrieb des Rechnersystems gewährleisten, in gespiegelten Form vorhanden sind (Security-Bereich), in welcher diesezunächst nicht zur Ausführung bringbar sind, ist es möglich, nach dem Umbenennen der mit Defekt festgestellten Datei in eine nicht aufrufbare und einem weiteren Umbenennungsvorgang der gespiegelt vorhandenen Datei in eine entsprechend aufrufbare Form, mit diesen Daten das Rechnersystem weiter zu betreiben. Die entsprechenden Umbenennungsvorgänge werden dabei durch eine Programmroutine im Rechnersystem ausgeführt. Lediglich in denjenigen Fällen, in welchen der Rechner nicht mehr von der Platte zu booten ist, erfolgt das Einlegen einer Diskette und das Starten des Rechners von Diskette aus. Derartige Fälle sind aber sehr selten, so daß die vorliegende Erfindung einen eingrifffreien Weiterbetriebs bei den meisten Störungsfällen gewährleistet.

Durch das sofortige Umbenennen einer mit einem Defekt festgestellten Datei in eine nicht zur Ausführung bringbaren Form wird die mit einem physikalischen Defekt versehene Datei an dem physikalischen Speicherort (Sektor) belassen. Durch dieses Umbenennen ist somit der entsprechende Festplattenbereich gegen weitere Schreib-/Lesevorgänge gesperrt. Dadurch, daß bei der Installation des Rechnersystems, d.h. also dem Abspeichern der Programmteile bzw. Files auf der Festplatte zumindest bestimmte Programmteile bzw. Files (Security-Bereich) dem Inhalt nach doppelt (gespiegelt) abgelegt werden, wobei in der gespiegelten Form diese Programmteile bzw. Files nicht aufrufbar sind, ist es möglich nach dem Umbenennungsvorgang der mit einem Defekt festgestellten Datei durch einen weiteren Umbenennungsvorgang der redundant vorliegenden Programmdatei diese logisch an die Stelle der mit Defekt festgestellten Datei treten zu lassen. Durch das Umbenennen der defekten Datei (Beschädigung der Plattenoberfläche) wird der entsprechende Festplattenbereich gegen weitere Zugriffe gesperrt und durch den weiteren Umbenennungsvorgang (gespiegelte Datei zunächst nicht aufrufbar - nach Umbenennen in ausführbare Form versetzt) tritt logisch eine sich in einwandfreiem Zustand befindliche Datei an die Stelle der ursprünglichen. Durch das erfindungsgemäße Rechnersystem erfolgt somit nicht nur eine Feststellung bzw. Prüfung, ob eine Datenmanipulation durch Computer-Viren oder physikalische Defekte stattgefunden hat, sondern ebenfalls auch ein als "Selbstheilung" bezeichenbarer Regenerierungsvorgang.

Nach der Erfindung kann dabei vorgesehen sein, daß die Überprüfung der vorgesehenen Files auf einwandfreien Zustand hin bei jedem Booten des Rechnersystems erfolgt. Ferner kann vorgesehen sein, daß ebenfalls vor jedem Zugriff auf die entsprechenden Dateien, um diese beispielsweise in das RAM zu laden und daraufhin zur Ausführung zu bringen, eine entsprechende Überprüfung auf einwandfreien Zustand hin erfolgt. Beiden Fällen ist es dabei gemeinsam, daß bei Feststellen einer entsprechenden Abweichung bzw. eines Defektes die entsprechenden Umbenennungsvorgänge eingeleitet werden. Die Datei mit einem physikalischen Defekt oder eine Datei, welche durch sonstige Manipulation verändert worden ist, wird dabei in einen nicht aufrufbaren Zustand umbenannt und die entsprechend gespiegelt vorhandene Datei, welche sich an einem physikalisch anderen Speicherort befindet, wird in einen aufrufbaren Zustand versetzt. Es erfolgt somit eine Regeneration von gestörten Daten, wobei der physikalische Speicherbereich, welcher eine als gestört festgestellte Datei enthält, gleichzeitig gegen weitere Zugriffe zwecks Schreiben bzw. Lesen gesperrt wird.

Für die Feststellung, ob Dateien sich in einem einwandfreien Zustand befinden oder nicht, gibt es mehrere Möglichkeiten. Zum einen kann vorgesehen sein, daß ein Vergleich des Inhaltes der für den Sicherheits-Check vorgesehenen Dateien mit den zweiten, gespiegelt vorliegenden und nicht zur Ausführung bringbaren Dateien durchgeführt wird. Dies kann beispielsweise bei jedem Boot-Vorgang des Rechners bzw. vor dem Aufrufen (Laden ins RAM des Rechners) erfolgen.

Eine Überprüfung von Dateien bzw. Files auf einen ordnungsgemäßen Zustand hin, also ob ein physikalischer Defekt der Festplatte oder eine bspw. durch Viren verursachte Manipulation von Daten vorliegt, kann aber auch dadurch erfolgen, daß bei einem Boot-Vorgang des Rechnersystems bzw. vor dem Aufrufen des entsprechenden Programmteiles eine Prüfsummenbildung entsprechend einem vorgegebenen Algorithmus erfolgt. Das Ergebnis dieser gemäß vorgegebenem Algorithmus durchgeführten Prüfsummenbildung wird dann mit einem entsprechend gebildeten und auf der Festplatte abgespeichertem Wert verglichen. Bei der werksseitigen Installation des Rechnersystems, d.h. dem Abspeichern der entsprechenden Programmteile bzw. Files auf der Festplatte werden die entsprechenden Prüfsummenwerte der für den Security-Check vorgesehenen Dateien bzw. Files auf der Festplatte abgespeichert. Bei diesen Programmen bzw. Files wurde zuvor mit aufwendigen Prüfmethoden bzw. Prüfprogrammen ein einwandfreier Zustand festgestellt.

Wird beim Starten des Rechnersystems bzw. vor dem Zugriff auf eine vorgesehene Datei ein Fehler eines oder mehrerer Files mittels einem durch das Festplattenlaufwerk generierten und einen physikalischen (Lese-)Fehler anzeigenden Signal festgestellt, so erfolgt - in dem für die Speicherverwaltung vorgesehenen Speicher - eine sofortige Umbenennung dieser Datei in eine derartige Form, so daß ein File bzw. eine Datei vorliegt, welche unter dem ursprünglichen Namen (File-Bezeichnung) nicht mehr aufrufbar und zur Ausführung bringbar ist. Da vorgesehen ist, bereits bei der Installation des Rechnersystems bestimmte Dateien bzw. Files sowohl in einer aufrufbaren als auch nicht aufrufbaren Form doppelt abzuspeichern, ist es möglich, diese Files bzw. Dateien durch die bereits weiter vorstehend genannten Umbenennungsvorgänge in eine Form zu wandeln, so daß mit diesen Daten bzw. Files ein zumindest vorübergehender Betrieb des Rechnersystems möglich ist. Die mit physikalischem Defekt festgestellte Datei wird zunächst in eine nicht aufrufbare Form umbenannt und dadurch auch der entsprechende Bereich des Speichermediums (Sektoren der Festplatte) gegen weitere Zugriffe durch das Betriebssystem bzw. der menuegeführten Benutzeroberfläche gesperrt. Nach dem Umbenennen und somit Sperren der mit einem Defekt festgestellten Datei erfolgt wiederum ein Umbenennen der gespiegelt vorliegenden und in der ursprünglichen Form nicht aufrufbaren, inhaltlich identischen Datei bzw. Files, so daß dieses Programm an die Stelle des mit Defekt festgestellten Programmes tritt. Sämtliche Schreib- bzw. Lesevorgänge, welche unter Angabe des entsprechenden Dateinamens erfolgen, werden somit nicht mehr an dem Orte der Festplatte mit physikalischen Defekt durchgeführt sondern an dem Ort, an welchem sich die gespiegelte Datei befindet.

Erfindungsgemäß ist weiterbildend vorgesehen, daß der zuvorstehend geschilderte und als Regenerierung eines fehlerhaften Programmteiles bezeichenbare Vorgang unter Anzeige einer Fehlermeldung sowie eines den Rechnerzustand protokollierenden Speichervorganges selbsttätig abläuft. Der Benutzer des erfindungsgemäßen Rechnersystems hat somit während dieses automatisch ablaufenden Umsteuervorganges (defekte Datei wird durch die gespiegelt vorhandene, intakte Datei ersetzt) keinerlei Handhabung durchzuführen. Entsprechend der dabei angezeigten Fehlermeldung sind lediglich nachfolgende Servicemaßnahmen einzuleiten, wobei die Protokollierung des Rechnerzustandes während des erfindungsgemäß vorgesehenen Umsteuervorganges eine zusätzliche Erleichterung ergibt. Durch die Protokollierung ist dabei feststellbar, ob eine Datei wirklich nur durch einen physikalischen Defekt (Beschädigung der Festplatte) gestört worden ist oder ob eine Manipulation aufgrund eines Computer-Virus oder dgl. vorliegt.

## Patentansprüche

1. Rechner für den Leitstand einer Druckmaschine, mit wenigstens einem wiederbeschreibbaren, nicht flüchtigen Speicher, insbesondere in Form eines Festplattenlaufwerkes und einer wiederbeschreibbaren, flüchtigen Speichereinrichtung (RAM), wobei der Inhalt von im wiederbeschreibbaren, nicht flüchtigen Speicher enthaltenen Dateien auf den wiederbeschreibbaren, flüchtigen Speicher (RAM) übertragbar und gegebenenfalls zur Ausführung bringbar ist,
**dadurch gekennzeichnet,**
**daß** der wiederbeschreibbare, nicht flüchtige Speicher den Inhalt wenigstens einer Datei redundant in einer aufrufbaren und zur Ausführung bringbaren als auch in einer durch das Betriebssystem nicht aufrufbaren, nicht zur Ausführung bringbaren Form enthält, daß vor dem Übertragen des aufrufbaren und zur Ausführung bringbaren Inhaltes einer derartigen Datei von dem wiederbeschreibbaren, nicht flüchtigen Speicher in den wiederbeschreibbaren, flüchtigen Speicher (RAM) eine Überprüfung des Inhaltes der Datei gemäß vorgegebenen Kriterium durchführbar ist, und daß bei Nichterfüllen des Kriteriums die entsprechende Datei in einen nicht aufrufbaren Zustand sowie der zunächst nicht aufrufbare und zur Ausführung bringbare Inhalt der Datei in einen aufrufbaren und zur Ausführung bringbaren Zustand versetzbar und daraufhin der Inhalt in den wiederbeschreibbaren, flüchtigen Speicher (RAM) übertragbar ist.

2. Rechner nach Anspruch 1,
**dadurch gekennzeichnet,**
**daß** zur Überprüfung einer Datei ein Vergleich der Inhalte der in aufrufbarer und zur Ausführung bringbarer als auch in nicht aufrufbarer, nicht zur Ausführung bringbarer Form im wiederbeschreibbaren, nicht flüchtigen Speicher abgelegten Datei durchführbar ist.

3. Rechner nach Anspruch 1,
**dadurch gekennzeichnet,**
**daß** der wiederbeschreibbare, nicht flüchtige Speicher durch bei der Systeminstallation gemäß vorgegebener Prüfalgorithmen bildbare Prüfwerte enthält und zur Überprüfung einer Datei die Bildung des entsprechenden Prüfwertes durchführbar ist.

4. Rechner nach den Ansprüchen 1, 2 oder 3,
**dadurch gekennzeichnet,**
**daß** entsprechend dem Ergebnis der Überprüfung des Inhaltes einer Datei eine Fehlermeldung darstellbar ist.

5. Rechner nach einem der vorhergehenden Ansprüche,
**dadurch gekennzeichnet,**
**daß** das Überprüfen des Inhaltes einer Datei bei jedem Systemstart, d.h. Booten, durchführbar ist.

## Claims

1. Computer for the control desk of a printing press with at least one re-writable, non-volatile memory, particularly in the form of a hard disk drive and a re-writable, volatile storage device (RAM), wherein the content of data files contained in the rewritable, non-volatile memory can be transferred to the re-writable, volatile memory (RAM) and if desired brought to execution, **characterised in that** the rewritable, non-volatile memory contains the content of at least one data file redundantly in a form which can be called up and brought into operation and also in a form which cannot be called up by the operating system and not be brought into operation, that prior to the transfer of the content of such a data file which can be called up and which can be brought into operation from the re-writable, non-volatile memory into the rewritable, volatile memory (RAM), a checking of the content of the data file can be carried out in accordance with predetermined criteria, and that on the non-fulfilment of the criteria, the corresponding data file can be changed over to a non-callable up condition as well as the initially non-callable up and executable content of the data file into a callable up and bringable into execution condition, and thereafter the content can be transferred into the re-writable, volatile memory (RAM).

2. Computer according to Claim 1, **characterised in that** for checking a data file, a comparison can be carried out of the contents of the form of the file which can be called up and brought to execution and also of the file in non-callable-up, non-executable form stored in the re-writable, non-volatile memory.

3. Computer according to Claim 1, **characterised in that** the re-writable, non-volatile memory contains check values which can be formed in accordance with preset checking algorithms on system installation and that for checking a data file, the formation of the corresponding check value can be carried out.

4. Computer according to Claims 1, 2 or 3, **characterised in that** corresponding to the result of the checking of the content of a data file, an error message can be displayed.

5. Computer according to one of the preceding Claims, **characterised in that** the checking of the content of a data file can be carried out on each system start, i.e. on booting.

## Revendications

1. Calculateur pour le poste de commande d'une machine d'impression, comportant au moins une mémoire non volatile réinscriptible, en particulier sous forme d'un lecteur de disque fixe, et un dispositif de mémoire volatile réinscriptible (RAM), le contenu de fichiers contenus dans la mémoire réinscriptible non volatile pouvant être transmis à la mémoire réinscriptible volatile (RAM) et, le cas échéant, exécuté,
**caractérisé en ce que** la mémoire réinscriptible non volatile contient le contenu d'au moins un fichier, de façon redondante, sous une forme pouvant être appelée et exécutée comme également sous une forme ne pouvant pas être appelée par le système d'exploitation, ni exécutée, **en ce que**, avant le transfert du contenu pouvant être appelé et exécuté d'un tel fichier de la mémoire réinscriptible non volatile dans la mémoire réinscriptible volatile (RAM), il peut être effectué une vérification du contenu du fichier selon un critère prédéfini, et **en ce que**, lorsque le critère n'est pas rempli, le fichier correspondant peut passer dans un état ne pouvant pas être appelé, ainsi que le contenu ne pouvant tout d'abord pas être appelé et exécuté du fichier, dans un état pouvant être appelé et exécuté et, ensuite, le contenu peut être transféré dans la mémoire réinscriptible volatile (RAM).

2. Calculateur selon la revendication 1,
**caractérisé en ce que**, pour vérifier un fichier, il peut être effectué une comparaison des contenus du fichier se trouvant dans la mémoire réinscriptible non volatile sous une forme pouvant être appelée et exécutée ainsi que sous une forme ne pouvant pas être appelée, ni exécutée.

3. Calculateur selon la revendication 1,
**caractérisé en ce que** la mémoire réinscriptible non volatile contient des valeurs de contrôle pouvant être formées suivant des algorithmes de contrôle prédéfinis lors de l'installation du système et, pour la vérification d'un fichier, la formation d'une valeur de contrôle correspondante peut être réalisée.

4. Calculateur selon la revendication 1, 2 ou 3,
**caractérisé en ce qu'**un message d'erreur peut être représenté de façon correspondant au résultat de la vérification du contenu d'un fichier.

5. Calculateur selon une des revendications précédentes,
**caractérisé en ce que** la vérification du contenu d'un fichier peut être effectuée à chaque démarrage du système, c'est-à-dire amorçage.
